# EUROPEAN PATENT APPLICATION

(11) **EP 1 931 035 A1**
(43) Date of publication of application: **11.06.2008**
(21) Application number: 07116591.4
(22) Date of filing: 17.09.2007
(51) Int. Cl.: H03M 13/27

(54) **Turbo decoder and turbo decoding method**

(30) Priority: 27.11.2006 JP 2006318331
(71) Applicant: FUJITSU LIMITED, Kawasaki-shi, Kanagawa 211-8588 (JP)
(72) Inventor: Ikeda, Norihiro c/o FUJITSU LIMITED, Kawasaki-shi, Kanagawa 211-8588 (JP)
(74) Representative: Stebbing, Timothy Charles

(57) **Abstract**

A turbo decoder includes a plurality of element decoders [12-i (i = 1 to M)], a memory section (15) that stores element decoded results in matrix-patterned memory spaces, and a memory controller (19) that writes the element decoded result of each of the element decoders (12-i) in a row or column direction in the matrix-patterned memory spaces with addresses belonging to different rows being specified as writing start addresses, and reads them in the column or row direction with the addresses belonging to different rows being specified as reading start address. As a result, conflict of accesses to the memory required for an interleaving process and a deinterleaving process to be executed at the turbo decoding step can be avoided.

## Description

The present invention relates to a turbo decoder and a turbo decoding method.

An error correcting code is used in systems which are required to transmit data without error at the time of data communication such as mobile communication, FAX and cash dispensers of banks or required to read data without error from high-capacity data media such as magnetic discs and CDs.

Turbo code, which is one kind of error correcting code, is a code whose coding gain is high in the error correcting code, and the turbo code is used in third-generation cellular phone systems in the field of mobile communication. Turbo code is expected to be used also in next-generation cellular phone systems.

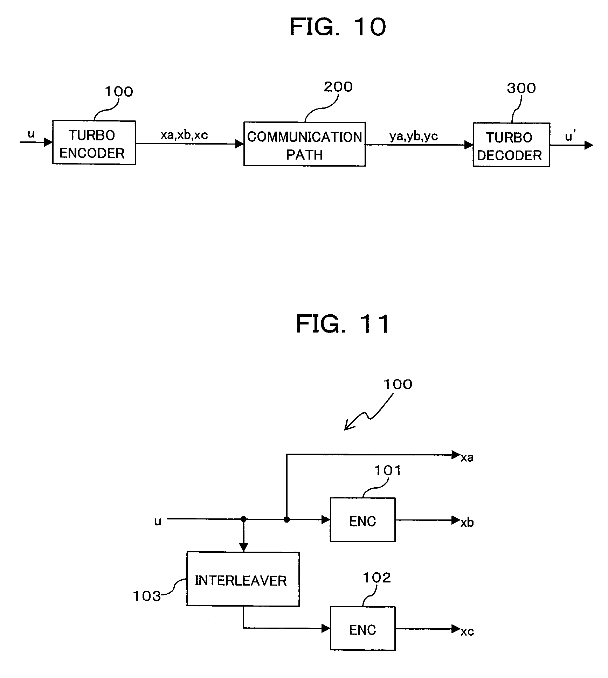

FIG. 10 illustrates a structure of a communication system including a turbo encoder and a turbo decoder. Symbols shown in FIG. 10 are as follows.

| | |
|---|---|
| Information | u = {u1, u2, ···, uN} |
| Coded data | xa = {xa1, xa2, ···, xak, ···, xaN} |
| | xb = {xb1, xb2, ···, xbk, ···, xbN} |
| | xc = {xc1, sc2, ···, xck, ···, xcN} |
| Received data | ya = {ya1, ya2, ···, yak, ···, yaN} |
| | yb = {yb1, yb2, ···, ybk, ···, ybN} |
| | yc = {yc1, yc2, ···, yck, ···, ycN} |
| Decoded result | u' = {u'1, u'2, ···, u'N} |

In the communication system shown in FIG. 10, information u with length of N-bit is coded into coded data xa, xb and xc by a transmitter (turbo encoder 100). When being transmitted through a communication path 200, the coded data are influenced by noise, fading or the like and are received as received signals ya, yb and yc by a receiver (turbo decoder 300). The turbo decoder 300 executes a decoding process on the received signals ya, yb and yc so as to obtain decoded result u'.

FIG. 11 illustrates a main structure of the turbo encoder 100. The turbo encoder 100 shown in FIG. 11 includes two element encoders (ENC) 101 and 102 and an interleaver 103. The turbo encoder 100 transmits a set of information u (xa) to be transmitted, coded data (xb) obtained by convolution-encoding the information u before interleaving via the interleaver 103 using the element encoder 101, and coded data (xc) obtained by convolution-encoding the information u interleaved by the interleaver 103 using the other encoder 102 as the turbo codes.

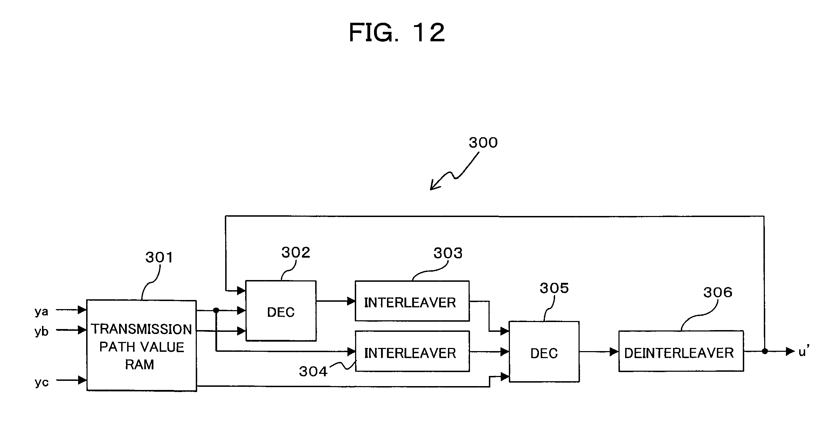

On the other hand, the turbo decoder 300, as shown in FIG. 12 for example, includes a transmission path value memory (RAM) 301, two element decoders (DEC) 302 and 305, two interleavers 303 and 304 and a deinterleaver 306.

In the turbo decoder 300, the element decoder 302 performs element decoding using transmission path values stored in the transmission path value RAM 301, namely, a set of received signals ya and yb among the received signals ya, yb and yc. Decoding methods such as MAP (Maximum A Posteriori Probability) and SOVA (Soft Output Viterbi Algorithm) can be used for the element decoding.

Then, the element decoder 305 performs element decoding using a set of a signal representing the likelihood of the decoded result and the received signal yc. At this time, the likelihood of the decoded result in the element decoder 302 is interleaved by the interleaver 303 so as to be input into the element decoder 305.

The likelihood of the decoded result in the element decoder 305 is deinterleaved by the deinterleaver 306 so as to be again input into the element decoder 302. Thereafter, the turbo decoder 300 repeats the above process a predetermined number of times so as to executes the turbo decoding process, thereby improving error rate performance.

The operating principles of the turbo encoder and the turbo decoder are described in detail in paragraphs 0002 to 0028 of the following Patent Document 1, for example.

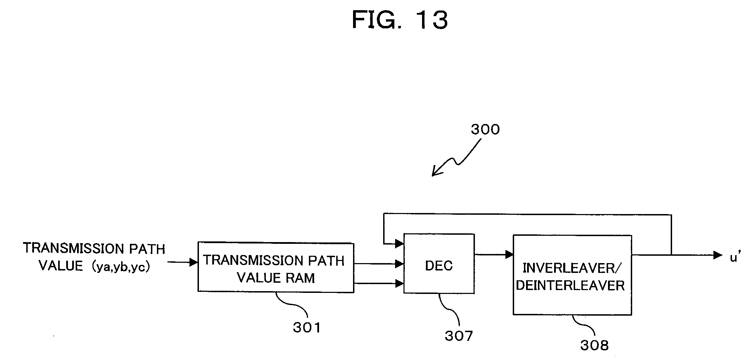

FIG. 12 illustrates the two element decoders 302 and 305, the two interleavers 303 and 304 and the deinterleaver 306 as components of the turbo decoder 300 for the explanation about the principle of the turbo decoder. However, in the hardware structure, as shown in FIG. 13, for example, the two element decoders 302 and 305 are commoditized as a single element decoder 307, and the interleavers 303 and 304 and the deinterleaver 306 are commoditized as a single interleaver/deinterleaver (interleaving/deinterleaving RAM) 308. The commoditized element decoder 307 and the interleaver/deinterleaver 308 are generally operated in a time division manner at the time of interleaving and deinterleaving.

In the technical standard of W-CDMA systems [3rd Generation Partnership Project (3GPP)], the specification of the interleaver to be used for the turbo coding is defined in the following Non-Patent Document 1. In such a turbo decoder, the interleaver/deinterleaver executes an interleaving and deinterleaving process using a matrix-patterned memory space of R × C.

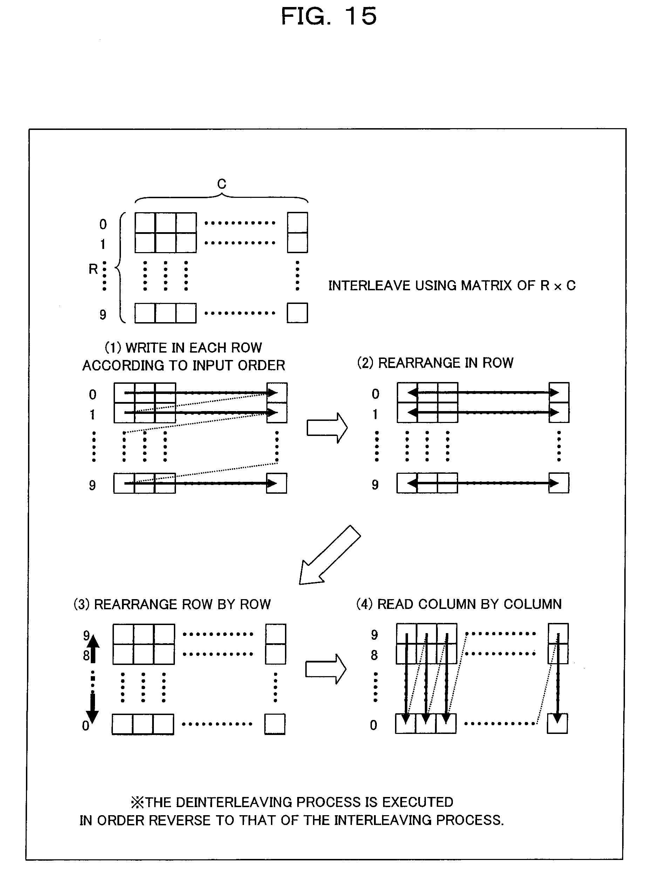

In other words, as conceptually shown in FIG. 15, for example, in the case of the interleaving operation, (1) input data for each row are sequentially written in a row direction according to input order by sequential (linear) writing address assignment (this is called linear access) . One of or both of (2) rearrangement in rows and (3) data rearrangement between rows (row unit) is/are carried out by reading address assignment based on a predetermined interleaving pattern, and (4) the data are read in a column direction.

The order of the data rearranging processes (2) and (3) is not important. The data rearrangement in the rows or between rows does not mean that storage positions in the memory space are actually changed, but means that the processes corresponding to the data rearrangement in rows and between rows are realized by the reading address specification based on the interleaving pattern (the same applies to the explanation hereinafter). The deinterleaving operation is performed in reverse order to the interleaving operation by the address specification based on the predetermined deinterleaving pattern.

The structure shown in FIG. 12 is one method for reducing the memory size required for the turbo decoder so as to reduce a circuit size, but a method of shortening the time required for decoding includes a method suggested in the following Patent Document 1.

In other words, the following Patent Document 1 describes that a signal to be decoded having information (code) length of N (bits) is divided into the M pieces (M is an integer of 2 or larger) of signals (blocks), and elements are decoded simultaneously and in parallel in the divided blocks of N/M-bits, thereby shortening (M-times speed process) the processing time.
[Patent Document 1] Japanese Patent Application Laid-Open No. 2004-15285
[Non-Patent Document 1] 3GPP TS 25.212 V6.9.0 (2006-09), Section 4.2.3.2 (Turbo coding)

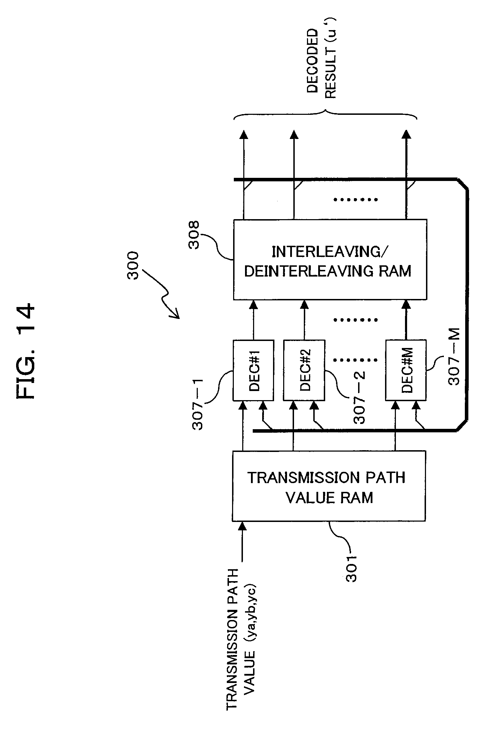

FIG. 14 illustrates a main structure of the turbo decoder to which the processing time shortening technique by means of the above-mentioned parallel providing of the element decoders is applied.

A turbo decoder 300 shown in FIG. 14 includes a transmission path value memory (RAM) 301, the M pieces (parallel) of element decoders (DEC#1 to DEC#M) 307-1 to 307-M, and an interleaving/deinterleaving memory (RAM) 308. Received signals (ya, yb and yc) of N-bits stored as the transmission path values in the transmission path value RAM 301 are divided into M, and the M pieces (subsets) of signals are processed simultaneously and in parallel in each block with information (code) length N/M by the element decoders 307-1 to 307-M, so as to be input into the interleaving/deinterleaving RAM 308.

In the interleaving/deinterleaving RAM 308, the plurality of element decoders 307-1 to 307-M is simultaneously accessed. For example, at the time of the interleaving operation, each of the element decoders 307-1 to 307-M decodes one of the divided blocks obtained by dividing the codes of N bits into M, and the element decoded results are written into the RAM 308 in the data output order by sequential (linear) address assignment (linear access). The M pieces of the element decoded results are read simultaneously and in parallel from the RAM 308 by address specification (predetermined interleaving pattern) after the interleaving. For this reason, M individual accesses to the RAM 308 are generated at the time of writing and at the time of reading.

In this case, at the time of writing, due to the linear access, the memory space of the RAM 308 is divided (bank division) by using upper addresses or the like, so that access conflict can be avoided. However, as a result of interleaving, access to the information M is approximately random at the time of reading, and thus a plurality of accesses to one bank at the same time is possibly generated. On the other hand, even if the RAM 308 is divided into banks according to the reading, the access becomes random at the time of writing, and thus access conflict possibly occurs.

For this reason, access conflict at the time of writing and reading cannot be avoided in simple bank division. The same applies to the deinterleaving operation, because the order of the address assignment at the time of writing and reading is the reverse of that of the interleaving operation.

In order to avoid such access conflict, a redundant memory capacity is provided, or an access clock speed of the RAM 308 is heightened, or the processing time is sacrificed.

Any of these measures, however, is not preferable because a circuit size, or processing time and current consumption, etc. are affected. Further, in the case where the number of the element decoders to be arranged in parallel is increased in order to realize a higher-speed process, it is very difficult to cope with the above problems by these methods.

The present invention is devised in view of the above problems, and embodiments thereof can avoid conflict of an access to a memory to be used in an interleaving process and a deinterleaving process to be executed at the turbo decoding step in a turbo decoder for operating a plurality of element decoders in parallel.

It is preferable to avoid the memory access conflict without increasing the capacity of a memory to be required for the interleaving process and the deinterleaving process to be executed at the turbo decoding step.

In the present invention, the following turbo decoder and turbo decoding method are used.

According to a first aspect of the present invention, a turbo decoder that repeats element decoding, interleaving and deinterleaving on a turbo coded signal so as to decode the signal, comprises: a plurality of element decoders that decodes divided signals obtained by dividing the signal to be decoded in parallel; a memory section that stores element decoded results of the element decoders into matrix-patterned memory spaces where reading and writing are possible in parallel on different rows; and a memory controller that writes the element decoded result of each of the element decoders in a row or column direction in the matrix-patterned memory spaces with addresses belonging to different rows being specified as writing start addresses, and reads the results in the column or row direction with the addresses belonging to the different rows being specified as reading start addresses so as to output them as the interleaved or deinterleaved results to the element decoders.

It is preferable that when the division number of the signal to be decoded is designated by M and the number of rows in the matrix-patterned memory spaces is designated by R (≥M), the number of columns is designated by C, and the number of bits of the signal to be decoded is designated by N (≤ R × C), the M pieces of the element decoders are provided, and the memory section includes the R pieces of memories with capacity of C bits so that the matrix-patterned memory spaces of R × C are composed.

When N < R × C, the memory controller may write padding data for (R × C - N) bits as the element decoded result from any of the element decoders into the memory section, or may perform a suspending operation so as to suspend the element decoding in the element decoders at the corresponding timing of reading the padding data into the element decoders.

When the element decoded results as reading start objects from the element decoders belong to the same column or row at the time of reading in the column or row direction, the memory controller may shift reading start timings of the element decoders.

The turbo decoder may further includes a buffer section that absorbs shifts in timings of input of the element decoded results into the element decoders due to the shift in the reading start timings.

The memory controller may adjust element decoding timings in the element decoders so that the shift in the timings of input of the element decoded results into the element decoders due to the shift in the reading start timings is absorbed.

According to a second aspect of the present invention, a turbo decoder that repeats element decoding, interleaving and deinterleaving on a turbo coded signal so as to decode the signal, comprises: a plurality of element decoders that decode divided signals obtained by dividing the signal to be decoded in parallel; a memory section that stores element decoded results of the element decoders in matrix-patterned memory spaces where the results can be read and written on different rows in parallel; a memory controller that writes the element decoded result of each of the element decoders in the row or column direction in the matrix-patterned memory spaces, and reads the results in the column or the row direction so as to output the results as interleaved or deinterleaved results to the element decoders; and a division number controller that controls the division number of the signal to be decoded according to a matrix size of the matrix-patterned memory spaces so that the element decoded result of each of the element decoders is written with addresses belonging to different rows being specified as writing start addresses, and the results are read with the addresses belonging to the different rows being specified as reading start addresses.

Further, according to a third aspect of the present invention, a turbo decoding method of repeating element decoding, interleaving and deinterleaving on a turbo coded signal so as to decode the signal, comprises the steps of: decoding divided signals obtained by dividing the signal to be decoded by means of a plurality of element decoders in parallel; and writing element decoded result in each of the element decoders in a row or column direction in matrix-patterned memory spaces of a memory section with addresses belonging to different rows being specified as writing start addresses, and reading the results in the column or row direction with the addresses belonging to the different rows being specified as reading start addresses so as to output the element decoded results as interleaved or deinterleaved results to the element decoders.

It is preferable that when the division number of the signal to be decoded is designated by M, the number of rows in the matrix-patterned memory spaces is designated by R (≥M), the number of columns is designated by C and the number of bits of the signal to be decoded is designated by N (≤ R × C), the M pieces of the element decoders are provided, and the memory section includes the R pieces of memories with capacity of C bits so that the matrix-patterned memory spaces of R × C are composed.

When N < R × C, padding data for (R × C - N) bits may be written as the element decoded result from any of the element decoders into the memory section, or a suspending operation may be performed so that the element decoding in the element decoders is suspended at the corresponding timing of reading the padding data into the element decoders.

When the element decoded results as reading start objects from the element decoders belong to the same column or row at the time of reading in the column or row direction, reading start timings of the element decoders may be shifted.

A buffer section may absorb shifts in timings of input of the element decoded results into the element decoders due to the shift in the reading start timings.

Element decoding timings in the element decoders may be adjusted so that the shift in the timings of input of the element decoded results into the element decoders due to the shift in the reading start timings is absorbed.

According to another aspect of the present invention, a turbo decoding method of repeating element decoding, interleaving and deinterleaving on a turbo coded signal so as to decode the signal, comprises the steps of: decoding divided signals obtained by dividing the signal to be decoded by means of a plurality of element decoders in parallel; and writing the element decoded result of each of the element decoders in a row or column direction in matrix-patterned memory spaces, and reading the results in the column or row direction so as to output the element decoded results as interleaved or deinterleaved results to the element decoders; and controlling the division number of the signal to be decoded according to a matrix size of the matrix-patterned memory spaces so that the element decoded result of each of the element decoders is written with addresses belonging to different rows being specified as writing start addresses, and the results are read with the addresses belonging to the different rows being specified as reading start addresses.

In embodiments of the present invention, after the element decoded result in each of the element decoders is written with the addresses belonging to the different rows in the matrix-patterned memory spaces where writing and reading are possible in parallel in the different rows being specified as the writing start addresses, the element decoded results are read with the addresses belonging to the different rows being specified as the reading start addresses. For this reason, at least the following effect and advantage can be obtained.

Namely, in the turbo decoder which operates a plurality of element decoders in parallel in order to carry out high-speed turbo decoding, memory access conflict can be avoided without increasing the capacity of memory required for the interleaving process and the deinterleaving process to be executed at the turbo decoding step and without increasing a memory access clock and a processing delay time.

The above and other features of the present invention will be understood by reading carefully the following description with accompanying drawings. Preferred embodiments of the present invention will be described in more detail referring to the accompanying drawings. The drawings are illustrative and are not to be limitative of the scope of the present invention.

In the drawings:
FIG. 1 is a block diagram illustrating a main structure of a turbo decoder according to a first embodiment of the present invention;
FIG. 2 is a conceptual diagram for explaining operations for writing and reading into/from a memory section of the turbo decoder shown in FIG. 1;
FIG. 3 is a conceptual diagram for explaining the operation for writing and reading into/from the memory section of the turbo decoder according to a modification of the first embodiment;
FIG. 4 is a block diagram illustrating the main structure of the turbo decoder according to a second embodiment of the present invention;
FIG. 5 is a conceptual diagram for explaining the operations for writing and reading into/from the memory section of the turbo decoder shown in FIG. 4;
FIG. 6 is a block diagram illustrating the main structure of the turbo decoder according to a first modification of the second embodiment;
FIG. 7 is a conceptual diagram for explaining the operations for writing and reading into/from the memory section of the turbo decoder shown in FIG. 6;
FIG. 8 is a block diagram illustrating the main structure of the turbo decoder according to a second modification of the second embodiment;
FIG. 9 is a conceptual diagram for explaining the operations for writing and reading into/from the memory section of the turbo decoder shown in FIG. 8;
FIG. 10 is a block diagram illustrating a structure of a communication system including a turbo encoder and the turbo decoder;
FIG. 11 is a block diagram illustrating a main structure of the turbo encoder;
FIG. 12 is a block diagram illustrating the main structure of the turbo decoder shown in FIG. 10;
FIG. 13 is a block diagram illustrating a modification of the turbo decoder shown in FIG. 12;
FIG. 14 is a block diagram illustrating the main structure of the turbo decoder to which a processing time shortening technique by means of parallel mounting of element decoders is applied; and
FIG. 15 is a conceptual diagram for explaining an interleaving process and a deinterleaving process to be executed at the turbo decoding step.

Preferred embodiments of the present invention are described in more detail below referring to the accompanying drawings.

The embodiments described below are only examples, and it goes without saying that they may be modified variously without departing from the scope of the present invention.

### [A] First Embodiment

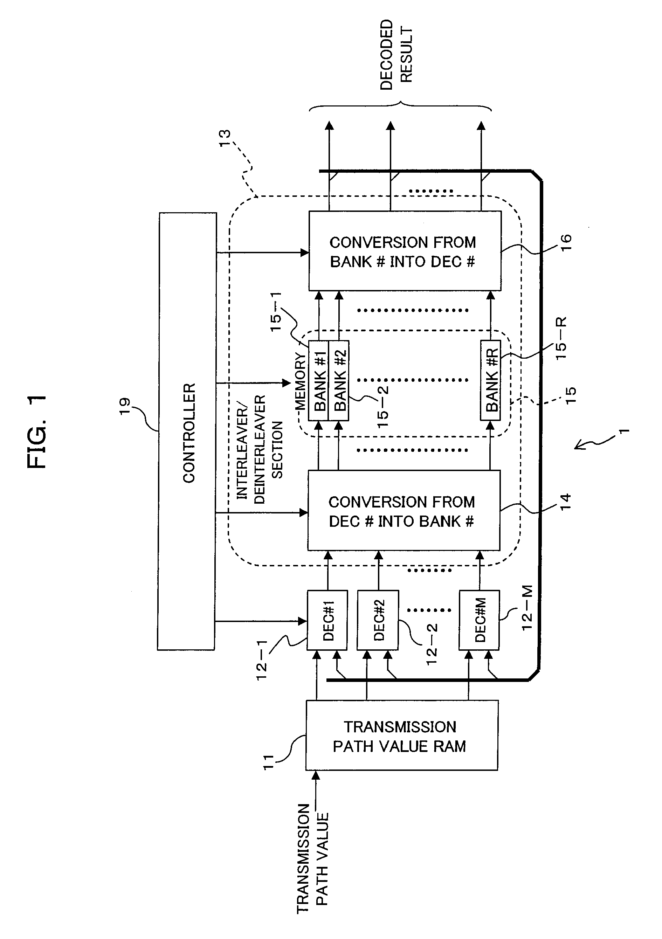

FIG. 1 is a block diagram illustrating a main structure of a turbo decoder according to a first embodiment of the present invention, and the turbo decoder 1 shown in FIG. 1 is applied to a receiver composing a communication system shown in FIG. 10, for example. The turbo decoder 1 includes a transmission path value memory (RAM) 11, the M pieces (M is an integer of 2 or larger) of elements decoders (DEC#1 to DEC#M) 12-1 to 12-M, and an interleaver/deinterleaver section 13. The interleaver/deinterleaver section 13 includes parallel number (DEC# → bank#) converting section (connection switching section) 14, a memory section 15, a parallel number (bank# → DEC#) converting section (connection switching section) 16, and a controller (memory controller) 19. A structure of the receiver (turbo encoder) is the same as or similar to a structure shown in FIG. 11, for example.

The transmission path value RAM 11 stores received signals (signals to be decoded) ya, yb, and yc explained above as transmission path values. Element decoders 12-i (i = 1 to M) performs element decoding using such as MAP or SOVA using information (transmission value and/or previous element decoded results after an interleaving or deinterleaving process) to be input from the transmission path value RAM 11 and/or the connection switching section 16 in each block (information length N/M-bit) obtained by dividing the information length N-bit of the transmission path value into M-block.

In other words, the element decoders 12-i firstly performs the element decoding using the received signal ya and one of the received signals yb or yc in the transmission path value RAM 11, and thereafter, repeatedly performs element decoding using previous element decoded results (likelihood) to be input from the connection switching section 16 and the received signal (yb or yc) which is not used in the previous element decoding process a predetermined number of times. This is executed on the divided signals obtained by dividing the signal to be decoded of N-bit into the M-piece of signals (blocks) simultaneously and in parallel.

The interleaver/deinterleaver section 13 is shared in the interleaving process and the deinterleaving process to be repeatedly executed alternately between the element decoding processes at the turbo decoding step. The interleaver/deinterleaver 13 rearranges data (the interleaving process or the deinterleaving process) as the element decoded results of the element decoders 12-i according to predetermined address assignment (an interleaving pattern or a deinterleaving pattern) . More concretely, the controller 19 controls the address assignment (a writing address or a reading address) for the memory section 15 according to the interleaving pattern or the deinterleaving pattern, so that the interleaving process and the deinterleaving process can be executed in the shared memory section 15.

The memory section 15 includes the R pieces of bank memories (#1 to #R) 15-1 to 15-R each having a capacity of C-bits in this example, and as a whole R rows × C columns matrix type memory spaces where writing and reading are possible on different rows in parallel are formed. The respective bank memories (hereinafter, simply banks) 15-j (j = 1 to R) are composed of single port RAMs, respectively.

In this example, the interleaving or deinterleaving process is executed on input data, namely, the element decoded results by using the R × C matrix-patterned memory spaces. More specifically, at the time of the interleaving operation, the input data are written (linear access) in a row direction according to an input order of the data (element decoded results) according to sequential (linear) writing address assignment in each of the element decoders 12-i. The dada are rearranged in rows and/or between rows (row unit) by reading address assignment according to a predetermined interleaving pattern so as to be read in a column direction.

In other words, the interleaving includes one or both of the rearranging processes in rows and between rows, but data written in a certain row (bank) are present on the same row (same bank) after the interleaving. When the block interleaver or an interleaver where the block interleaver and another interleaver are combined is used as the interleaver, memory access conflict can be avoided by applying the present invention. The deinterleaving operation is performed in reverse order (address assignment) to the interleaving process.

The connection switching section 14 selectively connects the element decoders 12-i and the bank memories 15-j, and outputs a decoded result from any one of the M parallel element decoders 12-i to any one of the R parallel bank memories 15-j. The controller 19 controls the switching of input and output so that for example, maximum C words in the M-parallel decoded results of N/M-bit obtained by the element decoders 12-j are input into each of the R parallel banks 15-j.

The connection switching section 16 selectively connects the banks 15-j to the element decoders 12-i, and can output (feed back) the interleaved or deinterleaved result of the element decoded result read from any one of the R parallel banks 15-j to any one of the M-parallel element decoders 12-i. The input and output are controlled to be switched so that, for example, N/M-bits of the R parallel decoded results read by maximum C-bit from the banks 15-j are input into each of the element decoders 12-i simultaneously and in parallel.

The controller 19 controls the operations of the element decoders 12-i and the interleaver/deinterleaver section 13 (the connection switching sections 14 and 16, and the memory section 15), and stores the interleaving pattern and the deinterleaving pattern in a memory such as RAM or ROM, not shown. The controller 19 controls the connection switching sections 14 and 16 in a predetermined cycle (the switching cycle of the interleaving and deinterleaving), and selectively uses any one of the patterns so as to specify the address of the memory section 15 according to the interleaving pattern at the time of the interleaving operation and the deinterleaving pattern at the time of the deinterleaving operation. As a result, the controller 19 controls the element decoding process, the interleaving process and the deinterleaving process at the turbo decoding step.

The operation of the turbo decoder 1 having the above structure is explained below. The transmission path value RAM 11 and the connection switching section 16 divide the signal of N-bits to be decoded into M sets, and input each set of N/M bits into the element decoders 12-i simultaneously and in parallel. The element decoders 12-i decode elements simultaneously and in parallel, and input the element decoded results into the interleaver/deinterleaver 13 (connection switching section 14) in M-parallel.

The connection switching section 14 outputs the element decoded results input in M-parallel into the banks 15-j of the memory section 15, respectively, according to the control by means of the controller 19. When the degree of parallelism M of the element decoders 12-i is the number of rows R of the interleaving (namely, the number of banks) or less (M ≤ R), a writing access of each of the element decoders 12-i to the memory section 15 (banks 15-j) becomes a linear access to the row direction (in the same bank 15-j) in the R × C matrix-patterned memory spaces of the memory section 15 at the time of the interleaving (writing). As a result, the element decoded results in the respective rows are sequentially written in the input order.

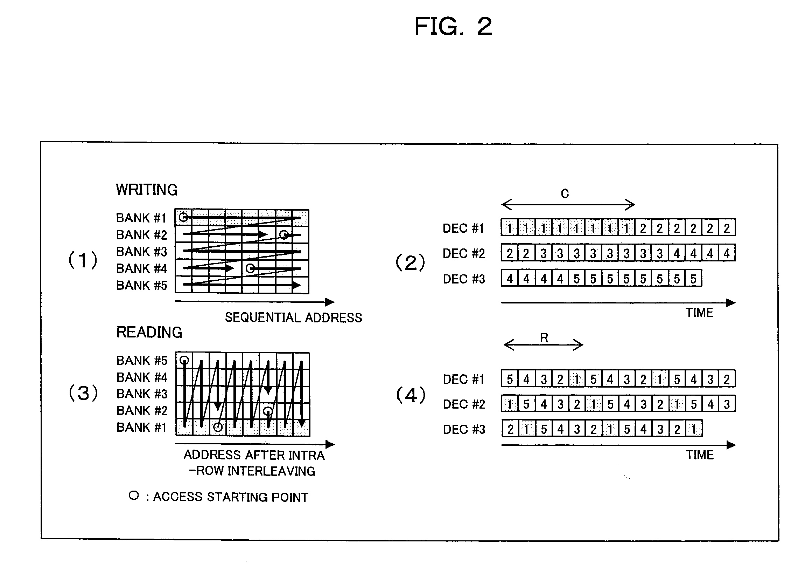

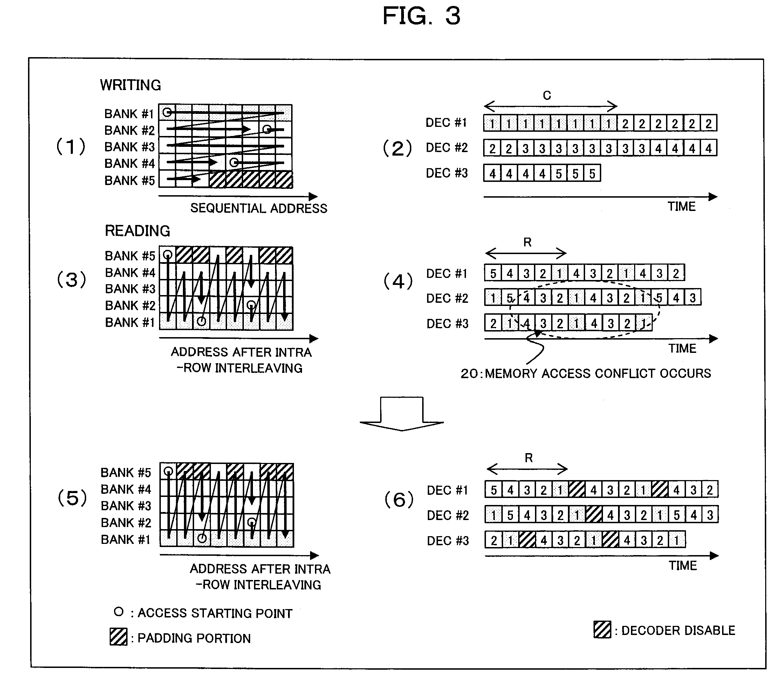

The concept of such an operation is shown in FIG. 2, for example. In FIG. 2, the parallel number M (the division number of signals to be decoded) of the element decoders 12-i is 3, the number of banks R is 5, and the capacity (bit number) C of each of the banks 15-j is 8, and a case where the matrix-patterned memory spaces of R × C = 5 × 8 are formed by the banks (#1 to #5) 15-1 to 15-5 is assumed. Section (2) of FIG. 2 expresses the output order of the element decoded results from the element decoders (#1 to #3) 12-1 to 12-3 on a time axis, and section (1) of FIG. 2 shows a state of accesses (writing address assignment) to the matrix at the time of writing the element decoded results. Section (3) of FIG. 2 shows a state of accesses (reading address assignment) to the data arrangement after the data rearrangement (interleaving) in rows and/or between rows on the matrix. Section (4) of FIG. 2 expresses the output order of the element decoded results read in the reading order shown in (3) of FIG. 2 to the element decoders 12-1 to 12-3 on a time axis. The numbers given to the element decoded results in sections(2) and (4) of FIG. 2 correspond to the numbers of the banks 15-j to which the element decoded results belong, respectively. The above expression applies also to FIGS. 3, 5, 7 and 9 to be used in the explanation hereafter.

In other words, in the turbo decoder 1 of this example, as shown in (1) and (2) of FIG. 2, as to the first C (= 8)-bit parts of the results of decoding the signals to be decoded with N = 40 bits simultaneously and in parallel by the element decoders 12-1 to 12-3 are written into the bank 15-1 corresponding to the first row of the matrix, and the following C-bit portions are written into the bank 15-2 corresponding to the second row of the matrix from the respective head addresses sequentially. Similarly, the element decoded results for C bits are written into the bank 15-j corresponding to the j-th row of the matrix from its head address sequentially.

Therefore, the addresses (access starting points) where the simultaneous accesses to the banks 15-j from the element decoders 12-1 to 12-3 are generated are separated from each other by a distance of C (= 8) or more (the access starting points from the element decoders 12-1 to 12-3 become addresses which belong to different rows). For this reason, the simultaneous accesses to the same bank 15-j are not generated.

On the other hand, at the time of reading, as shown in (3) of FIG. 2, the reading accesses of the element decoders 12-1 to 12-3 become linear accesses to the row direction (namely, different banks 15-j). For this reason, a reading access is generated in each of the banks 15-1 to 15-5 sequentially once in R cycle, so that the element decoded results are read. Therefore, the access conflict does not occur as along as the first reading accesses (access starting points) of the element decoders 12-1 to 12-3 to different banks 15-j are generated.

At the time of deinterleaving, the address specification for writing and reading is carried out in reverse order to that of the above interleaving. More specifically, the access to each of the banks 15-j is generated sequentially every R cycles, and the element decoded results are written into the banks 15-j (namely, the column direction), whereas the element decoded results are read from each of the banks 15-j by linear access in the row direction. Therefore, also at the time of the writing and the reading in the interleaving operation, the access conflict can be avoided.

The element decoded results read from the banks 15-j (interleaved or deinterleaved results) are input into the connection switching section 16 simultaneously and in parallel, and are input into the M parallel element decoders 12-i in units of N/M bits.

According to the turbo decoder 1 of this embodiment, the element decoded results in the element decoders 12-i are written in the row direction (or column direction) with addresses belonging to the different rows in the R × C matrix-patterned memory spaces being specified as the access starting points (writing start addresses), and the results are read in the column direction (or row direction) with the addresses belonging to the different rows being specified as the access starting points (reading start addresses). For this reason, access conflict on the same bank 15-j can be avoided at the time of the interleaving process and the deinterleaving process which are repeated alternately at the turbo decoding step.

Therefore, in a turbo decoder where a plurality of element decoders are operated in parallel in order to carry out high-speed turbo decoding, memory access conflict is avoided without increasing the memory capacity required for the interleaving process and the deinterleaving process and without increasing the memory access clock and the processing delay time, thereby realizing the correct turbo decoding operation.

### (A1) Modification

In the structure of the turbo decoder 1 shown in FIG. 1, in the case, when the bit number N of the element decoded results to be input into the interleaver/deinterleaver section 13 is N < R × C, dummy bits of a number (R × C - N) are added so that the interleaver/deinterleaver section 13 executes the interleaving or deinterleaving process. That is, at least one dummy bit is added to the data end of the element decoded results with N-bit in the element decoders 12-i and the dummy bit is deleted (skipped) at the time of outputting (reading) from the memory section 15. In such a case, conflict of access to the memory section 15 occasionally occurs depending on the interleaving pattern (deinterleaving pattern).

As shown in (2) of FIG. 3, for example, when the bit number N of the element decoded results from the element decoders 12-1 to 12-3 is 35 (< 5 × 8 = 40), five dummy bits (= 40 - 35) are added, and as shown by a slanted line portion in (1), the dummy bits are written into the bank 15-5 corresponding to the final row of the R × C (5 × 8) matrix. Similarly to the example of (3) in FIG. 2, as shown in (3) of FIG. 3, when the element decoded results are read in the column direction after the interleaving process between rows and in rows, the controller 19 assigns the reading addresses so that the dummy bits shown by the slanted line portion are skipped.

As a result, the element decoded results are output (input) to the element decoders 12-1 to 12-3 in an order shown in (4) of FIG. 3. Focusing on the element decoders 12-2 and 12-3, since the bank numbers on the bit columns shown by a dotted line frame 20 are common, regarding banks 15-1 to 15-4, the reading access from the plurality of element decoders 12-2 and 12-3 to the banks 15-1 to 15-4 are generated at the same time, thereby the access conflict is caused.

In this example, on the premise of the structure shown in FIG. 1, in order to avoid the access conflict, the element decoders 12-i as the output destinations of the dummy bits at the time of reading are controlled to be disabled (suspended) at the timing of the dummy bit. As a result, the operation similar to that in the above embodiment [(3) and (4) of FIG. 2) is realized. In other words, as shown in (5) and (6) of FIG. 3, the controller 19 controls to disable the corresponding element decoders 12-1 to 12-3 at the time when the dummy bits shown by the slanted line portion are input into the element decoders 12-1 to 12-3. As a result, the access conflict shown by the frame 20 in (4) of FIG. 3 due to deletion of dummy bits can be avoided. The suspending operation may be performed at the time of writing the dummy bits.

### [B] Second Embodiment

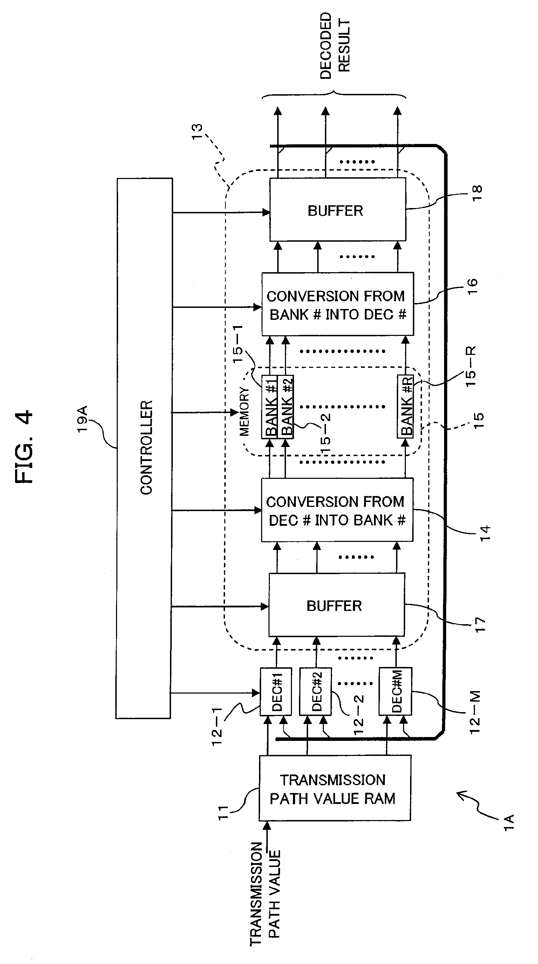

FIG. 4 is a block diagram illustrating a main structure of a turbo decoder according to a second embodiment of the present invention. The turbo decoder 1A shown in FIG. 4 is different from the turbo decoder 1 shown in FIG. 1 in that a buffer section 17 is provided onto an input side of the connection switching section 14 and a buffer section 18 is provided onto an output side of the connection switching section 16 in the interleaver/deinterleaver section 13, and a controller (memory controller) 19A is provided instead of the controller 19. The other components having the same reference symbols have the same or similar functions as/to those of the above-mentioned components unless otherwise noted.

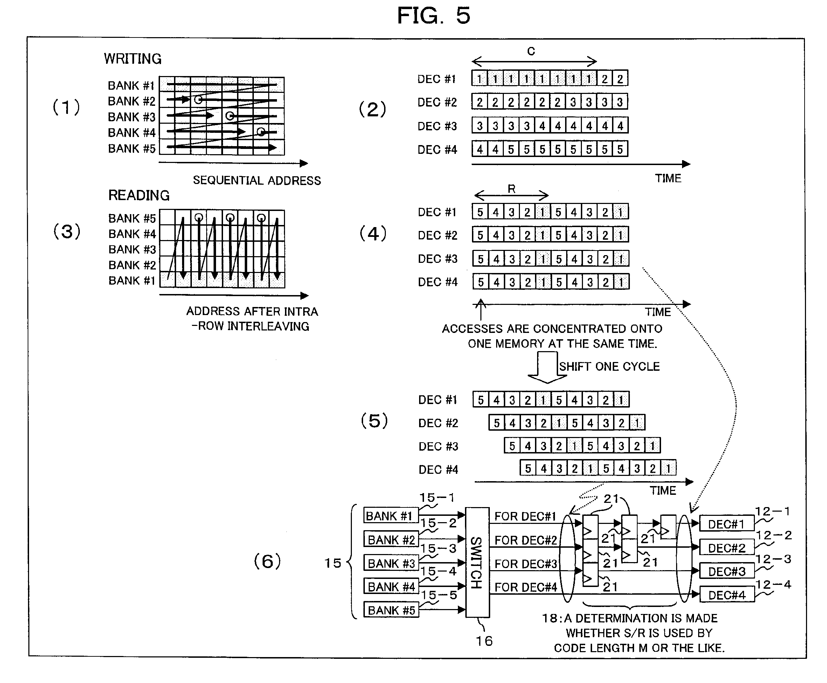

The buffer sections 17 and 18 can adjust (delay) output timings (phases) of the M-parallel input data (element decoded results) individually under the control of the controller 19A. Focusing on the buffer section 18, as shown in (6) of FIG. 5, for example, (M-i) individual delay devices (shift registers: SR) 21 having the same delay amount (for example, 1 bit) are interposed sequentially on data lines connected to the element decoders 12-i in M-parallel data lines between the connection switching section 16 and the element decoders 12-i (here, i = 1 to 4), or the buffer section 18 has equivalent structure. The buffer section 18 shifts (delays) the M-parallel element decoded results by one bit between the element decoders 12-i so as to be capable of outputting them to the element decoders 12-i.

The buffer section 17 has a structure such that (i-1) delay devices 21 having the same delay amount (for example, 1 bit) are provided on data lines connected to the element decoders 12-i in the M-parallel data lines between the element decoders 12-i and the connection switching section 14, or has an equivalent structure. The buffer section 17 shifts (delays) the M pieces of parallel element decoded results by one bit between the element decoders 12-i so as to be capable of outputting them to the connection switching section 14.

The number of the delay devices 21 through which the element decoded results go on the data lines can be controlled suitably by the controller 19A.

The buffer sections 17 and 18 are provided to the interleaver/deinterleaver section 13, so that the reading access starting points can be changed in each of the banks 15-j at the time of reading the element decoded results from the memory section 15 (banks 15-j). In other words, even when the reading access starting points in the banks 15-j are changed, the controller 19A controls the number of the delay devices 21 though which the element decoded results read from the banks 15-j go in the buffer sections 17 and 18. As a result, the phases (input timings) of M pieces of the parallel element decoded results to be output to the element decoders 12-i or the connection switching section 14 can be aligned.

The reading access starting points in the banks 15-j need to be changed because the data about the decoding start points (timings) of the different element decoders 12-i are occasionally present in the same bank 15-j depending on the size of the matrix and the number of parallel element decoders 12-i.

For example, in the case where the size of the matrix R × C is 5 × 8, the number M of parallel element decoders 12-i is 4 and the information length N of the block to be decoded is 40 (= R × C), as shown in (1) and (2) of FIG. 5, the access in the row direction in each element decoder 12-i becomes linear at the time of writing. For this reason, each set of ten element decoded results are sequentially written into each row (each bank 15-j) . As shown in (3) of FIG. 5, since the access is in the column direction in each element decoder 12-i at the time of reading, the access to the banks 15-j is generated sequentially once in R cycle so that the element decoded results are read.

Therefore, since the writing access starting points of the respective element decoders 12-i at the time of writing are present in different banks 15-j (separated by distance of C or more), the conflict of the access to the same bank 15-j does not occur. As shown in (3) and (4) of FIG. 5, however, since the reading access starting points from the element decoders 12-i to the banks 15-j are concentrated on the one bank 15-5 at the same time, conflict of access to the banks 15-5 occurs.

In this case, the access conflict cannot be avoided only by dividing the bank into the R pieces of banks 15-j. Therefore, the controller 19A shifts the timings of reading accesses to the banks 15-j by one cycle (one bit) in the respective element decoders 12-i as shown in (5) of FIG. 5, so that the reading accesses to the one bank 15-j at the same time can be avoided.

The buffer section 18 is provided so as to correct to realign irregularity (phase shift) of the input timings of the M pieces of the parallel element decoded results to the element decoders 12-i caused by shifting the reading access timings, and absorbs the phase shift. The buffer section 17 operates so as to absorb the phase shift between the M pieces of the parallel element decoded results at the time of the deinterleaving operation.

### (B1) First Modification

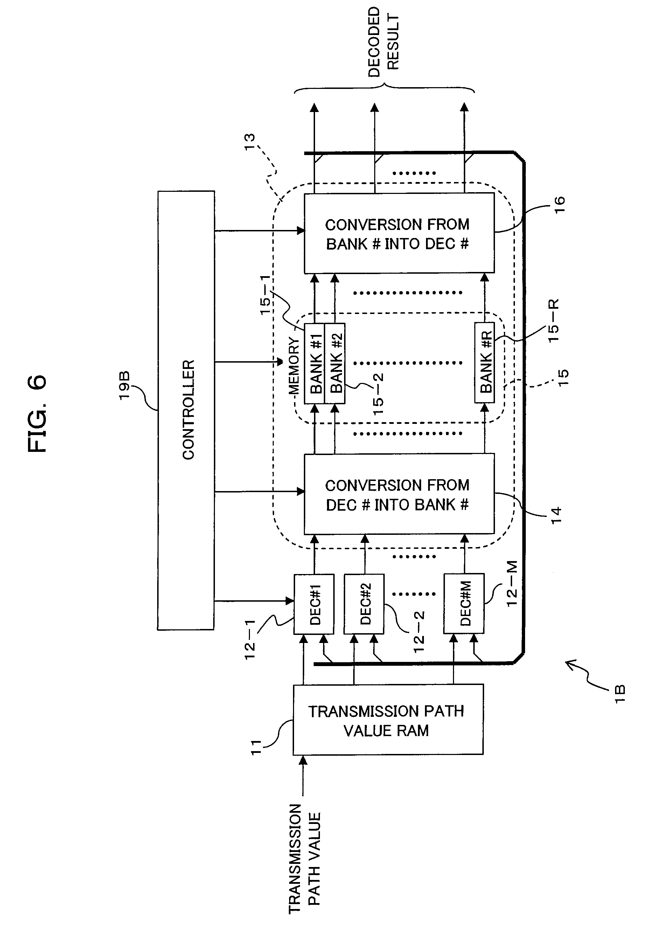

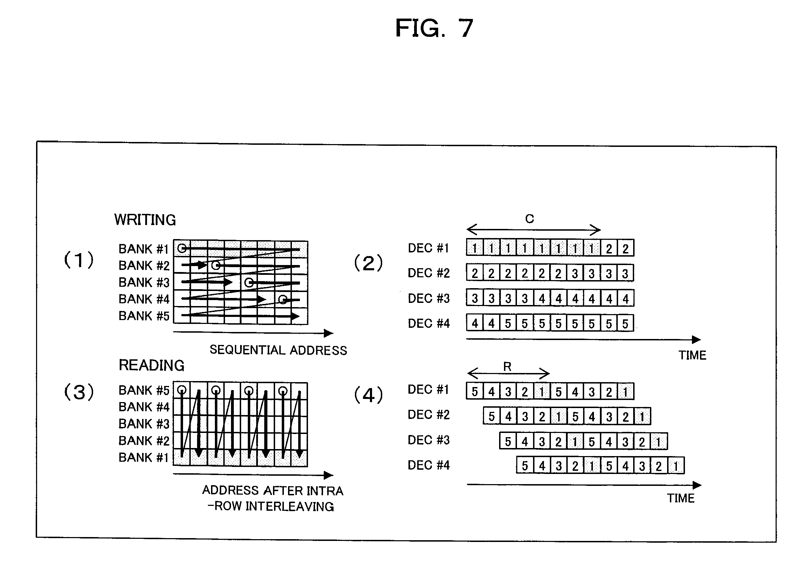

In the second embodiment, when M pieces of the parallel element decoders 12-i do not have to be operated simultaneously, as shown in FIG. 6, the element decoders 12-i are operated by the controller (memory controller) 19B with the decoding start timings being shifted according to the phase shift. As a result, the phase shift between M pieces of the parallel element decoded results does not have to be absorbed by the buffer sections 17 and 18 (see (1) to (4) of FIG. 7).

As shown in FIG. 6, therefore, the turbo decoder 1B of this example, which has the structure of the turbo decoder 1 in the first embodiment as a basic structure, can avoid the access conflict in the case where the data about the decoding start points of the respective element decoders 12-i are present in one bank 15-j.

### (B2) Second Modification

The second embodiment and the first modification include a measure to determine the code length and the number M of parallel element decoders 12-i to unique constants during the decoding of received signals, and on the premise of no dynamic change during the decoding, avoid the access conflict which is caused by a specific relationship between the code length (the size of the matrix) and the number M of the parallel element decoders 12-i. For example, however, the number of operations of the element decodes 12-i (namely, the division number M of the signal to be decoded) can be controlled so that the data about the decoding start points of the element decoders 12-i are stored in the different banks 15-j. Namely, the access conflict also can be avoided with control of the information length in each element decoder 12-i.

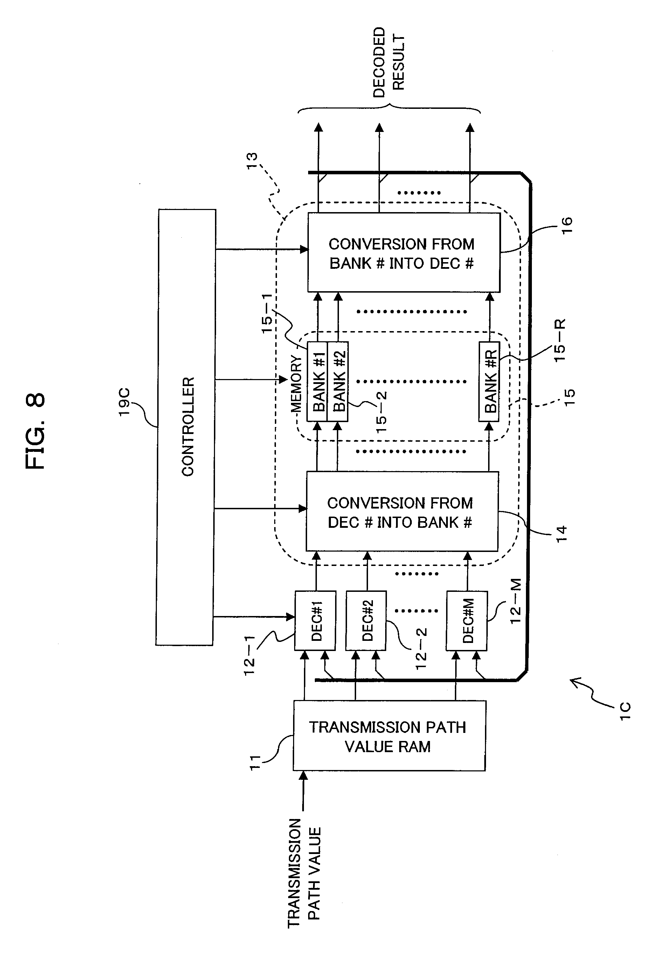

In this case, as shown in FIG. 8, the turbo decoder 1C basically includes the transmission path value memory (RAM) 11, the element decoders 12-1 to 12-M, the interleaver/deinterleaver section 13 [the connection switching section 14, the memory section 15 (banks 15-1 to 15-R) and the connection switching section 16] and a controller (memory controller) 19C similarly to the turbo decoder 1 shown in FIG. 1. The controller 19C controls the number of operations of the element decoders 12-i to control the amount of data to be decoded in one element decoder 12-i, so as to be capable of storing the data about the decoding start points of the element decoders 12-i into the different banks 15-j.

In other words, the controller 19C in this case has a function as a division number controller which controls the division number M of sets of signals to be decoded so that after the element decoded results in the element decodes 12-i are written in the row direction (or column direction) according to the matrix size of the matrix-patterned memory spaces with the addresses belonging to different rows being specified as the access starting points (writing start addresses), the results are read in the column direction (or row direction) with the addresses belonging to different columns being specified as the access starting points (reading start addresses).

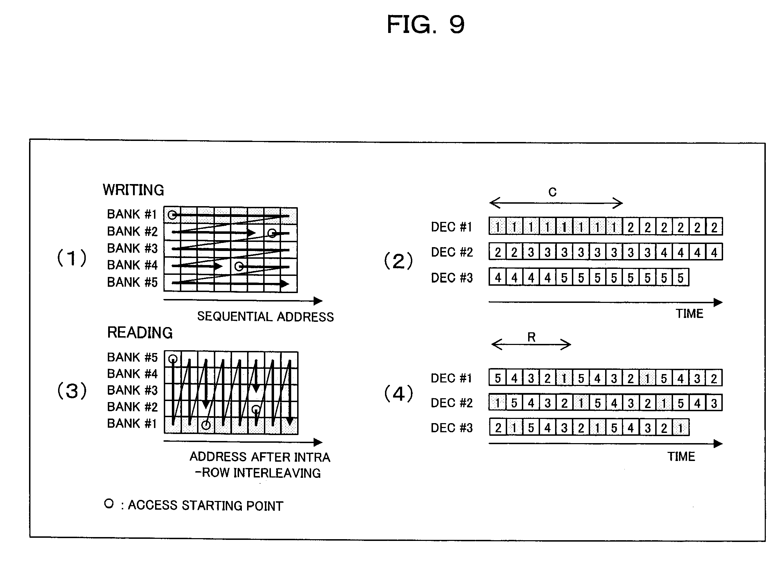

For example, as explained with reference to FIG. 5 or FIG. 7, in the case where the size of the matrix R × C is 5 × 8, the number M of parallel element decoders 12-i is 4 and the information length N in the block to be decoded is 40 (= R × C), the controller 19C ensures that only three (12-1 to 12-3) of the four element decoders 12-1 to 12-4 are operated. As a result, the operations for writing and reading into/from the memory section 15 (banks 15-j) are as shown in FIG. 9.

In other words, FIG. 9 is the same as FIG. 2, and as shown in (2) and (4) of FIG. 9, the data amount in one element decoder 12-i increases (from 10 bits to 14 bits) in comparison with the case where the four element decoders 12-i are operated. As shown in (3) of FIG. 9, since the starting points of the accesses of the element decoders 12-i to the banks 15-j can be dispersed in different banks 15-j at the time of reading, access conflict can be avoided.

At the time of the deinterleaving operation, the addresses for writing and reading are specified in the reverse order to that of the interleaving operation.

As this invention may be embodied in several,the present embodiments are therefore illustrative and not restrictive, since the scope of the invention is defined by the appended claims.

## Claims

1. A turbo decoder arranged to repeat element decoding, interleaving and deinterleaving of a turbo coded signal so as to decode the signal, comprising:
a plurality of element decoders (12-1 to 12-M) for decoding divided signals obtained by dividing the signal to be decoded in parallel;
a memory section (15) for storing element decoded results of the element decoders (12-1 to 12-M) intomatrix-patternedmemory spaces where reading and writing are possible in parallel on different rows; and
a memory controller (19) for writing the element decoded result of each of the element decoders (12-1 to 12-M) in a row or column direction in the matrix-patterned memory spaces with addresses belonging to different rows being specified as writing start addresses, and reading the results in the column or row direction with the addresses belonging to the different rows being specified as reading start addresses so as to output them as the interleaved or deinterleaved results to the element decoders (12-1 to 12-M).

2. The turbo decoder according to claim 1, wherein
when the division number of the signal to be decoded is designated by M, and the number of rows in the matrix-patterned memory spaces is designated by R (≥ M), the number of columns is designated by C, and the number of bits of the signal to be decoded is designated by N (≤ R × C),
M element decoders (12-1 to 12-M) are provided, and
the memory section (15) includes R memories (15-1 to 15-R) each with capacity of C bits to provide matrix-patterned memory spaces of R × C bits.

3. The turbo decoder according to claim 2, wherein when N < R × C, the memory controller (19) writes padding data for (R × C - N) bits as the element decoded result from any of the element decoders (12-1 to 12-M) into the memory section (15), or performs a suspending operation so as to suspend the element decoding in the element decoders (12-1 to 12-M) at the corresponding timing of reading the padding data into the element decoders (12-1 to 12-M).

4. The turbo decoder according to claim 1, wherein when the element decoded results as reading start objects from the element decoders (12-1 to 12-M) belong to the same column or row at the time of reading in the column or row direction, the memory controller (19) shifts reading start timings of the element decoders (12-1 to 12-M).

5. The turbo decoder according to claim 4, further comprising a buffer section (18) that absorbs shifts in timings of input of the element decoded results into the element decoders (12-1 to 12-M) due to the shift in the reading start timings.

6. The turbo decoder according to claim 4, wherein the memory controller (19) adjusts element decoding timings in the element decoders (12-1 to 12-M) so that the shift in the timings of input of the element decoded results into the element decoders (12-1 to 12-M) due to the shift in the reading start timings is absorbed.

7. A turbo decoder arranged to repeat element decoding, interleaving and deinterleaving of a turbo coded signal so as to decode the signal, comprising:
a plurality of element decoders (12-1 to 12-M) for decoding divided signals obtained by dividing the signal to be decoded in parallel;
a memory section (15) for storing element decoded results of the element decoders (12-1 to 12-M) in matrix-patterned memory spaces where the results can be read and written on different rows in parallel;
a memory controller (19) for writing the element decoded result of each of the element decoders (12-1 to 12-M) in the row or column direction in the matrix-patterned memory spaces, and reading the results in the column or the row direction so as to output the results as interleaved or deinterleaved results to the element decoders (12-1 to 12-M); and
a division number controller (19C) arranged to control the division number of the signal to be decoded according to a matrix size of the matrix-patterned memory spaces so that the element decoded result of each of the element decoders (12-1 to 12-M) is written with addresses belonging to different rows being specified as writing start addresses, and the results are read with the addresses belonging to the different rows being specified as reading start addresses.

8. A turbo decoding method of repeating element decoding, interleaving and deinterleaving on a turbo coded signal so as to decode the signal, comprising the steps of:
decoding divided signals obtained by dividing the signal to be decoded by means of a plurality of element decoders (12-1 to 12-M) in parallel; and
writing element decoded results in each of the element decoders (12-1 to 12-M) in a row or column direction in matrix-patterned memory spaces of a memory section (15) with addresses belonging to different rows being specified as writing start addresses, and reading the results in the column or row direction with the addresses belonging to the different rows being specified as reading start addresses so as to output the element decoded results as interleaved or deinterleaved results to the element decoders (12-1 to 12-M).

9. The turbo decoding method according to claim 8, wherein when the division number of the signal to be decoded is designated by M, the number of rows in the matrix-patterned memory spaces is designated by R (≥ M), the number of columns is designated by C, and the number of bits of the signal to be decoded is designated by N (≤ R × C),
M element decoders (12-1 to 12-M) are provided,
the memory section (15) includes R memories (15-1 to 15-R) each with capacity of C bits to formmatrix-patternedmemory spaces of R × C bits.

10. The turbo decoding method according to claim 9, wherein, when N < R × C, padding data for (R × C - N) bits are written as the element decoded result from any of the element decoders (12-1 to 12-M) into the memory section (15), or a suspending operation is performed so that the element decoding in the element decoders (12-1 to 12-M) is suspended at the corresponding timing of reading the padding data into the element decoders (12-1 to 12-M).

11. The turbo decoding method according to claim 8, wherein when the element decoded results as reading start objects from the element decoders (12-1 to 12-M) belong to the same column or row at the time of reading in the column or row direction, reading start timings of the element decoders (12-1 to 12-M) are shifted.

12. The turbo decoding method according to claim 11, wherein a buffer section (18) absorbs shifts in timings of input of the element decoded results into the element decoders (12-1 to 12-M) due to the shift in the reading start timings.

13. The turbo decoding method according to claim 11, wherein element decoding timings in the element decoders (12-1 to 12-M) are adjusted so that the shift in the timings of input of the element decoded results into the element decoders (12-1 to 12-M) due to the shift in the reading start timings is absorbed.

14. A turbo decoding method of repeating element decoding, interleaving and deinterleaving on a turbo coded signal so as to decode the signal, comprising the steps of:
decoding divided signals obtained by dividing the signal to be decoded by means of a plurality of element decoders (12-1 to 12-M) in parallel;
writing the element decoded result of each of the element decoders (12-1 to 12-M) in a row or column direction in matrix-patterned memory spaces, and reading the results in the column or row direction so as to output the element decoded results as interleaved or deinterleaved results to the element decoders (12-1 to 12-M); and
controlling the division number of the signal to be decoded according to a matrix size of the matrix-patterned memory spaces so that the element decoded result of each of the element decoders (12-1 to 12-M) is written with addresses belonging to different rows being specified as writing start addresses, and the results are read with the addresses belonging to the different rows being specified as reading start addresses.
